## Europäisches Patentamt
## European Patent Office
## Office européen des brevets

(19)

(11) Veröffentlichungsnummer: **0 145 916**
**B1**

(12) **EUROPÄISCHE PATENTSCHRIFT**

(45) Veröffentlichungstag der Patentschrift:
**31.05.89**

(51) Int. Cl.⁴: **H 05 K 5/02**

(21) Anmeldenummer: **84113177.4**

(22) Anmeldetag: **02.11.84**

(54) Schaltkasten.

(30) Priorität: **09.11.83 DE 8332164 U**

(43) Veröffentlichungstag der Anmeldung:
**26.06.85 Patentblatt 85/26**

(45) Bekanntmachung des Hinweises auf die Patenterteilung:
**31.05.89 Patentblatt 89/22**

(84) Benannte Vertragsstaaten:
**AT BE CH DE FR GB IT LI LU NL SE**

(56) Entgegenhaltungen:
**DE-A-2 623 540**
**DE-A-3 209 550**
**DE-U-7 624 442**
**US-A-3 937 352**

(73) Patentinhaber: **Rittal- Werk Rudolf Loh GmbH & Co. KG, Auf dem Stützelberg, D-6348 Herborn (DE)**

(72) Erfinder: **Laudt, Jürgen, Franzosenweg 7, D-6348 Herborn (DE)**

(74) Vertreter: **Vogel, Georg, Hermann- Essig- Strasse 35, D-7141 Schwieberdingen (DE)**

LIBER, STOCKHOLM 1989

EP 0 145 916 B1

## Beschreibung

Die Erfindung betrifft einen Schaltkasten aus einem boxartigen Unterteil mit Schließrand und einem die Öffnung des Unterteils verschließenden Stülpdeckel, der im Bereich aller Ecken mit Aufnahmebuchsen für Verbindungsschrauben versehen ist, die in Gewindeaufnahmen von Verbindungsflanschen einschraubbar sind, welche im Bereich der Öffnung in den Ecken des Unterteils angebracht sind.

Das Abnehmen des Deckels von dem Unterteil erfordert zeitraubende Montagearbeit, da alle Verbindungsschrauben aus den Gewindebohrungen der Verbindungsflansche herausgedreht werden müssen. Dies ist auch dann noch umständlich, wenn der Deckel mittels Scharniere einseitig an dem Unterteil angelenkt ist, und nur noch zwei Verbindungsschrauben gelöst werden müssen.

Es ist Aufgabe der Erfindung, bei einem Schaltkasten der eingangs erwähnten Art das Schließen und Öffnen des Deckels wesentlich zu vereinfachen, so daß die wenigen erforderlichen Montagearbeiten dazu schnell und leicht ausgeführt werden können.

Diese Aufgabe wird nach der Erfindung dadurch gelöst, daß auf den Verbindungsflanschen ein Schloßelement mit einer Aufnahme für einen als Schließelement ausgebildeten Verbinder angebracht ist, der nur in einer vorgegebenen Winkelstellung in die Aufnahme des Schloßelementes einführbar und wieder herausführbar ist, durch Verdrehen aber axial unverschiebbar in der Aufnahme festlegbar ist.

Der Verbinder dieser Art stellt in Verbindung mit dem Schloßelement auf dem Verbindungsflansch einen Schnellverschluß dar, bei dem mit kleiner Drehbewegung die Ver- und Entriegelung durchgeführt werden kann. Dabei bieten das Schloßelement und der als Schließelement ausgebildete Verbinder die Möglichkeit, diese Art Schnellverschlüsse auch an bereits ausgelieferten Schaltkästen auf einfache Weise nachzurüsten.

Dabei hat sich weiterhin als zweckmäßig erwiesen, daß der Verbinder in der zugeordneten Aufnahmebuchse unverlierbar gehalten ist, die selbst unverlierbar im Deckel gehalten ist. Die Verbinder sind dann auch in der gelösten Stellung am Deckel gehalten und können nicht verloren werden.

Die Anbringung der Schloßelemente an den Verbindungsflanschen ist nach einer Ausgestaltung so gelöst, daß die Verbindungsflansche außerhalb der Gewindeaufnahme für die Verbindungsschraube eine Bohrung für eine in eine Befestigungsbohrung des Schloßelementes eingeführte Befestigungsschraube aufweisen.

Zusätzliche Befestigungsmöglichkeiten für das Schloßelement werden nach einer weiteren Ausgestaltung dadurch geschaffen, daß das Schloßelement quaderförmig ausgebildet und in den parallel zu der Aufnahme und der Befestigungsbohrung gerichteten Seitenwänden mit zusätzlichen Befestigungsaufnahmen, z. B. Sackloch-Gewindeaufnahmen, versehen ist.

Soll der Deckel schnell vollständig von dem Unterteil gelöst werden können, dann sieht eine Ausgestaltung vor, daß die Verbindungsflansche in allen vier Ecken Schloßelemente tragen und als Schließelemente ausgebildete Verbinder aufnehmen.

Bei einem am Unterteil angelenkten Deckel ist dagegen die Ausgestaltung so, daß die beiden einer Seite des Schaltkastens zugeordneten Verbindungsflansche Schloßelemente tragen und als Schließelemente ausgebildete Verbinder aufnehmen und daß an der gegenüberliegenden Seite der Deckel mittels Scharniere mit dem Unterteil gelenkig verbunden ist.

Der als Schließelement ausgebildete Verbinder und das Schloßelement mit der dazugehörigen Aufnahme sind nach einer Ausgestaltung so ausgelegt, daß der Verbinder an seinem Einführende mit einem bartartigen Schließansatz versehen ist, daß die Aufnahme im Schloßelement eine Nut für den Schließansatz aufweist und daß die Aufnahme nach der Einführtiefe des Verbinders in eine erweiterte Halteaufnahme für den Schließansatz übergeht. Wird der Schließansatz des Verbinders in die erweiterte Halteaufnahme eingedreht, ist er axial unverschiebbar gehalten und der Deckel wird am Unterteil gehalten. Dabei läßt sich der Deckel auf einfache Weise dadurch gegen das Unterteil verspannen, wenn nach einer weiteren Ausgestaltung vorgesehen ist, daß der Übergang von der Aufnahme in die Halteaufnahme als Spannkurve für den Schließansatz des Verbinders ausgebildet ist.

Das Einführen des Verbinders in die Aufnahme des Schloßelementes wird dadurch erleichtert, daß der Verbinder am freien Ende in eine Einführschräge ausläuft und daß die Aufnahme auf der Einführseite sich konisch erweitert.

Die unverlierbare Festlegung des Verbinders in der Aufnahmebuchse wird nach einer Ausgestaltung dadurch erreicht, daß der Schließansatz als getrenntes Teil in eine Aufnahme des Verbinders eingesetzt ist. Dieser Schließansatz wird erst nach dem Einsetzen des Verbinders in die Aufnahmebuchse eingesetzt.

Eine andere Ausgestaltung von Verbinder und Schloßelement ist dadurch gekennzeichnet, daß der Verbinder einen Schlitz für einen Schloßstift des Schloßelements aufweist und daß der Schlitz im Verbinder sich in Längsrichtung des Verbinders als Schließkurve für den Schloßstift verdreht. Dabei hintergreift der Schloßstift des Schloßelements einen Teil des Verbinders, wenn der Verbinder nach dem Einführen des Schloßstiftes in den Schlitz des Verbinders verdreht und dabei weiter eingeführt wird.

Die Erfindung wird anhand eines in der Zeichnung dargestellten Ausführungsbeispiels näher erläutert. Es zeigt:

Fig. 1 im Teilschnitt eine Verbindung des Deckels und des Unterteils mit dem Schloßelement und dem Verbinder nach der Erfindung,

Fig. 2 das Schloßelement nach Fig. 1 in Draufsicht und

Fig. 3 einen Schnitt durch das Schloßelement nach Fig. 2, entlang der Linie III - III.

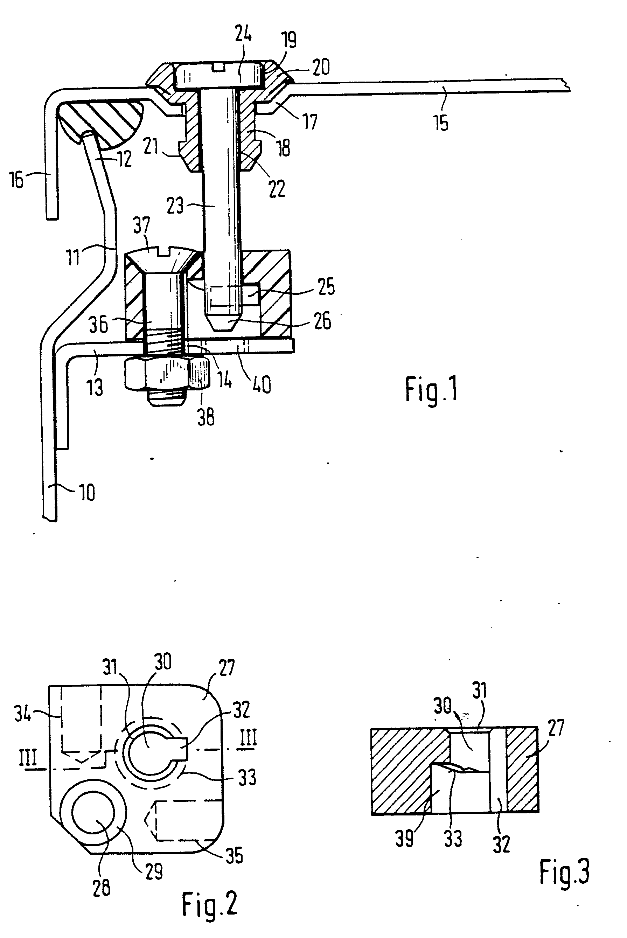

Von dem Schaltkasten ist in Fig. 1 das Unterteil 10 mit dem auslaufenden Schließrand 11 und der Deckel 15 mit dem Rand 16 angedeutet. Die gezeigte Verbindung erfolgt im Bereich einer Ecke, an der der Deckel 15 eine Einsickung 17 mit Durchgangsloch aufweist. In dieses Durchgangsloch ist die Aufnahmebuchse 18 eingerastet, wie die Rastelemente 21 zeigen. Die Aufnahmebuchse 18 weist eine erweiterte Aufnahme 19 für den mit Schlitz versehenen Kopf 24 des Verbinders 23 auf. Der Rand 20 um diese Aufnahme 19 verhindert ein Abgleiten des Schraubendrehers beim Drehen des Verbinders 23. Die Bohrung 22 der Aufnahmebuchse 18 nimmt den Schaft des Verbinders 23 auf. Der Verbinder 23 wird in die eingerastete Aufnahmebuchse 18 eingeschoben. Dann wird am freien Ende in die vorher eingebrachte Aufnahme der Schließansatz 25 eingesetzt, der nach Art eines Schlüsselbartes am Schaft des Verbinders 23 absteht. Das Ende des Verbinders 23 ist als Einführschräge 26 ausgebildet.

An der Innenseite des Unterteils 10 ist der winkelförmige Verbindungsflansch 13 angebracht, dessen Gewindebohrung 40 auf die Mittelachse der Aufnahmebuchse 18 ausgerichtet ist. Außerhalb der Gewindebohrung 40 ist in den Verbindungsflansch 13 die Bohrung 14 für die Befestigungsschraube 36 eingebracht, mit der das quaderförmige Schloßelement 27 auf dem Verbindungsflansch 13 befestigt wird. Der Linsenkopf 37 der Befestigungsschraube 36 liegt dabei versenkt in der Ansenkung 29 der Befestigungsbohrung 28 des Schloßelelementes 27. Mit der Mutter 38 wird die Verbindung zwischen dem Schloßelement 27 und dem Verbindungsflansch 13 vervollständigt. Mit den seitlichen Befestigungsaufnahmen 34 und 35, die z. B. als Gewindeaufnahmen ausgebildet sein können, läßt sich das Schloßelement 27 auch anders befestigen.

Das Schloßelement 27 weist die Aufnahme 30 für den Verbinder 23 auf, die auf dessen Mittelachse ausgerichtet ist und die Nut 32 trägt. Diese Nut 32 geht durch das Schloßelement 27 und stellt sicher, daß der Verbinder 23 nur in der Winkelstellung, in der der Schließansatz 25 in die Nut 32 eingreift, in die Aufnahme 30 eingeführt werden kann. Die konische Erweiterung 31 an der Einführseite erleichtert das Einführen des Verbinders 23 in die Aufnahme 30. Ist der Deckel 15 auf das Unterteil 10 geschwenkt oder gelegt, dann liegt der Schließrand 11 mit dem Dichtende 12 an dem Dichtungselement des Deckels 15. Der Verbinder 23 wird gedreht, wobei der Schließansatz 25 auf der Spannkurve 33 in die erweiterte Halteaufnahme 39 eingedreht wird. Dabei wird über den Verbinder 23 eine Spannkraft zwischen Deckel 15 und Unterteil 10 erzeugt und der Schließansatz 25 des Verbinders 23 axial unverschiebbar in der Aufnahme 30, d.h. dem Übergang zur Halteaufnahme 39, festgehalten.

Das Schloßelement 27 und der Verbinder 23 können an jedem Eck des Schaltkastens nachgerüstet werden, da die Verbindungsflansche 13 schon angebracht sind. Die Verbindungsschrauben werden durch Verbinder 23 ersetzt. Sind alle vier Ecken des Deckels 15 mit derartigen Schnellverschlüssen versehen, dann kann der Deckel 15 schnell und leicht vollständig vom Unterteil 10 gelöst werden. Ist der Deckel 15 einseitig am Unterteil 10 angelenkt, dann läßt sich mit zwei derartigen Schnellverschlüssen der Deckel 15 schnell und leicht öffnen und wieder schließen.

Die Verriegelung zwischen dem Schloßelement 27 und dem Verbinder 23 läßt sich auch anders erreichen. So kann das Schloßelement 27 in der Aufnahme 30 einen Schloßstift tragen. Das Ende des Verbinders 23 trägt dann einen Schlitz, der den Schloßstift aufnimmt. Der Schlitz verdreht sich in Längsrichtung des Verbinders, so daß beim Einführen des Verbinders 23 in den feststehenden Schloßstift zwangsläufig die Drehbewegung des Verbinders 23 ausgeführt wird. Der Schloßstift hintergreift Teile des Verbinders 23 im Bereich des Schlitzes, so daß auch hier eine axiale Festlegung erreicht wird.

**Patentansprüche**

1. Schaltkasten aus einem boxartigen Unterteil mit Schließrand und einem die Öffnung des Unterteils verschließenden Stülpdeckel, der im Bereich aller Ecken mit Aufnahmebuchsen für Verbindungsschrauben versehen ist, die in Gewindeaufnahmen von Verbindungsflanschen einschraubbar sind, welche im Bereich der Öffnung in den Ecken des Unterteils angebracht sind,
dadurch gekennzeichnet,
daß auf den Verbindungsflanschen (13) ein Schloßelement (27) mit einer Aufnahme (30) für einen als Schließelement ausgebildeten Verbinder (23) angebracht ist, der nur in einer vorgegebenen Winkelstellung in die Aufnahme (30) des Schloßelementes (27) einführbar und wieder herausführbar ist, durch Verdrehen aber axial unverschiebbar in der Aufnahme (30) festlegbar ist.

2. Schaltkasten nach Anspruch 1,
dadurch gekennzeichnet,
daß der Verbinder (23) in der zugeordneten Aufnahmebuchse (18) unverlierbar gehalten ist, die selbst unverlierbar im Deckel (15) gehalten ist.

3. Schaltkasten nach Anspruch 1 oder 2,

dadurch gekennzeichnet,
daß die Verbindungsflansche (13) außerhalb der Gewindeaufnahme (40) für die Verbindungsschraube eine Bohrung (14) für eine in eine Befestigungsbohrung (28) des Schloßelementes (27) eingeführte Befestigungsschraube (36) aufweisen.

4. Schaltkasten nach einem der Ansprüche 1 bis 3,
dadurch gekennzeichnet,
daß das Schloßelement (27) quaderförmig ausgebildet und in den parallel zu der Aufnahme (30) und der Befestigungsbohrung (28) gerichteten Seitenwänden mit zusätzlichen Befestigungsaufnahmen (34, 35), z. B. Sackloch-Gewindeaufnahmen, versehen ist.

5. Schaltkasten nach einem der Ansprüche 1 bis 4,
dadurch gekennzeichnet,
daß die Verbindungsflansche (13) in allen vier Ecken Schloßelemente (27) tragen und als Schließelemente ausgebildete Verbinder (23) aufnehmen.

6. Schaltkasten nach einem der Ansprüche 1 bis 4,
dadurch gekennzeichnet,
daß die beiden einer Seite des Schaltkastens zugeordneten Verbindungsflansche (13) Schloßelemente (27) tragen und als Schließelemente ausgebildete Verbinder (23) aufnehmen und daß an der gegenüberliegenden Seite der Deckel (15) mittels Scharniere mit dem Unterteil (10) gelenkig verbunden ist.

7. Schaltkasten nach einem der Ansprüche 1 bis 6,
dadurch gekennzeichnet,
daß der Verbinder (23) an seinem Einführende mit einem bartartigen Schließansatz (25) versehen ist,
daß die Aufnahme (30) im Schloßelement (27) eine Nut (32) für den Schließansatz (25) aufweist und
daß die Aufnahme (30) nach der Einführtiefe des Verbinders (23) in eine erweiterte Halteaufnahme (39) für den Schließansatz (25) übergeht.

8. Schaltkasten nach Anspruch 7,
dadurch gekennzeichnet,
daß der Übergang von der Aufnahme (30) in die Halteaufnahme (39) als Spannkurve (33) für den Schließansatz (25) des Verbinders (23) ausgebildet ist.

9. Schaltkasten nach Anspruch 7 und 8,
dadurch gekennzeichnet,
daß der Verbinder (23) am freien Ende in eine Einführschräge (26) ausläuft und
daß die Aufnahme (30) auf der Einführseite sich konisch erweitert.

10. Schaltkasten nach einem der Ansprüche 7 bis 9,
dadurch gekennzeichnet,
daß der Schließansatz (25) als getrenntes Teil in eine Aufnahme des Verbinders (23) eingesetzt ist.

11. Schaltkasten nach einem der Ansprüche 1 bis 6,
dadurch gekennzeichnet,
daß der Verbinder (23) einen Schlitz für einen Schloßstift des Schloßelementes (27) aufweist und
daß der Schlitz im Verbinder (23) sich in Längsrichtung des Verbinders (23) als Schließkurve für den Schloßstift verdreht.

## Claims

1. A switch box comprising a box-like bottom portion with a closure edge and a cover which fits thereover and which closes the opening of the bottom portion and which is provided in the region of all corners with mounting bushes for connecting screws which can be screwed into screwthreaded mountings of connecting flanges which are disposed in the region of the opening in the corners of the bottom portion,
characterised in
that mounted on the connecting flanges (13) is a lock element (27) with a mounting (30) for a connector (23) which is in the form of a closure element and which can be introduced into and removed again from the mounting (30) of the lock element (27), only in a predetermined angular position, and which can be axially immovably fixed in the mounting (30) by being turned.

2. A switch box according to claim 1,
characterised in
that the connector (23) is non-detachably held in the associated mounting bush (18) which itself is non-detachably held in the cover (15).

3. A switch box according to claim 1 or 2,
characterised in
that outside the screwthreaded mounting (40) for the connecting screw the connecting flanges (13) have a bore (14) for a fixing screw (36) which is fitted into a fixing bore (28) of the lock element (27).

4. A switch box according to one of claims 1 to 3,
characterised in
that the lock element (27) is of a parallelepipedic configuration and is provided with additional fixing mountings (34, 35), for example screwthreaded blind hole mountings, in the side walls which are directed parallel to the mounting (30) and the fixing bore (28).

5. A switch box according to one of claims 1 to 4,
characterised in
that the connecting flanges (13) carry lock elements (27) in all four corners and accommodate connectors (23) which are in the form of closure elements.

6. A switch box according to one of claims 1 to 4,
characterised in
that the two connecting flanges (13) associated with one side of the switch box carry lock elements (27) and accommodate connectors (23) which are in the form of closure elements and that at the opposite side the cover (15) is pivotally connected to the bottom portion (10) by means of hinges.

7. A switch box according to one of claims 1 to 6,

characterised in

that at its insertion end the connector (23) is provided with a bitlike closure projection (25),

that the mounting (30) in the lock element (27) has a groove (32) for the closure projection (25) and

that after the depth of insertion of the connector (23) the mounting (30) goes into an enlarged retaining mounting (39) for the closure projection (25).

8. A switch box according to claim 7,

characterised in

that the transition from the mounting (30) into the retaining mounting (39) is in the form of a tightening curve (33) for the closure projection (25) on the connector (23).

9. A switch box according to claim 7 and claim 8,

characterised in

that the connector (23) terminates with an insertion taper (26) at the free end and that the mounting (30) is enlarged in a conical configuration on the insertion side.

10. A switch box according to one of claims 7 to 9,

characterised in

that the closure projection (25) is fitted as a separate part into a mounting of the connector (23).

11. A switch box according to one of claims 1 to 6,

characterised in

that the connector (23) has a slot for a lock pin of the lock element (27) and that the slot in the connector (23) twists in the longitudinal direction of the connector (23) as a closing curve for the lock pin.


**Revendications**

1. Coffret électrique, de commande ou de distribution, constitué d'une partie inférieurte en forme de caisson avec un bord de fermeture et un couvercle en cloche fermant l'ouverture de la partie inférieure, et qui comporte dans la zone de tous les coins des douilles destinées à loger des vis de liaison que l'on peut visser dans des logements taraudés des rebords de liaison, rebords qui sont fixés dans la zone d'ouverture dans les coins de la partie inférieure,

coffret caractérisé en ce que,

sur les rebords (13) de liaison est fixé un élément (27) de serrure comportant un logement (30) pour un organe (23) de liaison en forme d'élément de fermeture, qui ne peut, qu'en position angulaire prédéterminée, être inséré dans le logement (30) de l'élément (27) de serrure et en être retiré à nouveau, mais qui, par rotation, peut être fermement maintenu sans pouvoir axialement coulisser dans le logement (30).

2. Coffret électrique selon la revendication 1,

caractérisé en ce que,

l'organe (23) de liaison est maintenu d'une manière imperdable dans la douille (18) réceptrice associée, qui est elle-même maintenue de façon imperdable dans le couvercle (15).

3. Coffret électrique selon la revendication 1 ou 2,

caractérisé en ce que,

les rebords (13) de liaison présentent, en dehors du logement (40) taraudé destiné à la vis de liaison, un alésage (14) destiné à recevoir une vis (36) de fixation introduite dans un alésage (28) de fixation ménagé dans l'élément (27) de serrure.

4. Coffret électrique selon l'une des revendications 1 à 3,

caractérisé en ce que,

l'élément (27) de serrure à une forme parallélépipédique et comporte, dans les parois latérales dirigées parallèlement au logement (30) et à l'alésage (28) de fixation, des logements (34, 35) supplémentaires de fixation, par exemple des logements taraudés en forme de trous borgnes.

5. Coffret électrique selon l'une des revendications 1 à 4,

caractérisé en ce que,

les rebords (13) de liaison comportent, dans l'ensemble des quatre coins, des éléments (27) de serrure et reçoivent des organes (23) de liaison en forme d'éléments de fermeture.

6. Coffret électrique selon l'une des revendications 1 à 4,

caractérisé en ce que,

les deux rebords (13) de liaison associés à un côté du coffret électrique portent de éléments (27) de serrure et reçoivent des organes (23) de liaison en forme d'éléments des fermeture, et

en ce que, sur les côtés opposée, le couvercle (15) est articulé à l'aide de charnières à la partie inférieure (10).

7. Coffret électrique selon les revendications 1 à 6,

caractérisé en ce que,

l'organe (23) de liaison comporte, à son extrémité d'introduction, une saillie (25) de fermeture en forme d'ergot ou de brabe de pène, en ce que le logement (30) ménagé dans l'élément (27) de serrure présente une gorge (32) destinée à recevoir la saillie (25) de fermeture, et en ce

qu'après la profondeur permettant l'introduction de l'orange (23) de liaison, le logement (30) se prolonge par un logement (39) élargi d'arrêt et de maintien de la saillie (25).

8. Coffret électrique selon la revendication 7,

caractérisé en ce que,

la zone de transition du logement (30) au logement (39) d'arrêt et de maintien a la forme d'une courbe ou came (33) de serrage de la saillie (25) de l'organe (23) de liaison.

9. Coffret électrique selon les revendications 7 et 8,

caractérisé en ce que,

l'organe (23) de liaison présente à son extrémité libre un biseau (26) pour en faciliter l'insertion et en ce que,

le logement (30) s'élargit coniquement du côté de l'insertion.

10. Coffret électrique selon l'une des revendications 7 à 9,

caractérisé en ce que,

la saillie (25) à rôle de fermeture, est placée à titre de pièce séparée dans un logement ménagé dans l'organe (23) de liaison.

11. Coffret électrique selon l'une des revendications 1 à 6,

caractérisé en ce que l'organe (23) de liaison présente une fente destinée à recevoir un goujon de l'élément (27) de serrure, et en ce que, la fente ménagée dans l'organe (23) de liaison se tord dans le sens longitudinal de cet organe (23) de liaison, en forme de courbe de fermeture pour le goujon de serrure.

Fig.1

Fig.2

Fig.3